# EUROPEAN PATENT SPECIFICATION

(11) **EP 3 203 533 B1**
(45) Date of publication and mention of the grant of the patent: **04.01.2023**
(21) Application number: 16460005.8
(22) Date of filing: 03.02.2016
(51) Int. Cl.: H01L 31/048, H02S 20/23, H02S 40/34, H02S 20/22, H02S 20/26

(54) **A LAMINATED THERMALLY INSULATING PHOTOVOLTAIC MODULE**
LAMINIERTES WÄRMEISOLIERENDES PHOTOVOLTAISCHES MODUL
MODULE PHOTOVOLTAÏQUE STRATIFIÉ THERMIQUEMENT ISOLANT

(43) Date of publication of application: 09.08.2017
(73) Proprietor: ML SYSTEM Spólka Akcyjna, 36-062 Zaczernie (PL)
(72) Inventor: Cycon, Dawid, 35-317 Rzeszów (PL); Chochorowski, Wiktor, 35-111 Rzeszów (PL)
(74) Representative: Warzybok, Tadeusz

(56) References cited:
- EP-A2- 0 884 432
- WO-A1-2014/162480
- DE-U1-202006 012 709
- JP-A- S60 138 952
- JP-A- 2012 254 529
- US-A1- 2014 238 468

## Description

The subject of the invention is a laminated thermally insulating photovoltaic module designed to acquire electric power by means of solar radiation conversion and easy to install on both walls and roofs of buildings.

Patent description JPS60164348 reveals a photovoltaic module with an array of photovoltaic cells integrated into a transparent filler, whereas the system is protected by two protective layers. One of the protective layers contains a structural load-bearing material which is a glass, and the second layer contains a multi-layer composite, forming this way an outer layer with a filler and the layer resistant to moisture.

From patent description US 2011/0041888A1 known is also an insulating construction panel with photovoltaic module designed to be integrated into building structures, comprising an insulating core top surface of which is covered with a rigid skin, said insulating core defining at least one rectangular opening extending all the way through the core in which a crystalline photovoltaic module having the outer surface made of a translucent pane is tightly fitted. On both of its longer sides, the insulation core has profiled ridges covered with the same rigid skin which on one of these ridges is bent downwards forming thus a longitudinal channel, whereas the opening or the openings with photovoltaic module or modules fitted in them are covered with movable insulating shutters. However, patent description of this invention does not reveal the type of materials of which the facings and the core of the panel are made.

Further, patent description PCT/EP 2013/073431-WO2014/086552A1 and European patent description EP2738318A1 teaches an insulating panel comprising an external sheet and an inner sheet with an insulating foam therebetween. The external sheet has a cut-away rectilinear opening in a flat portion thereof and a photovoltaic solar collector module is mounted in the opening provided in the external sheet by means of a gasket. Conductors of the module, through the foam pane, are led to a connection box embedded in the pane and adjacent to the inner sheet. The quoted description also lacks information about the type of material of which the two plates and the foam pane are made. Moreover, the external sheet of this composite insulating panel, outer face of which is co-planar with the outer face of the solar collector, has profiled gutter-shaped offsets on its longer sides used for joining adjacent panels.

The EP application EP 0 884 432 describes a solar cell integral type roof panel comprising solar cell strings encapsulated with an insulating material onto a galvanized steel sheet to form a solar cell integral, which is installed on a roofing base member of e.g. polystyrene foams, polyurethane foams, polyethylene foams, having a heat insulating performance, and covered by an under-roofing material having a water resistance.

From patent description US 2014/238468 A1 known is also a "Photovoltaic Module Assembly" in which the photovoltaic module has: a first layer made of poly(methyl methacrylate), polycarbonate, or polyamide; a back polymer layer comprising a second polymer layer with a cured composition and a PV cell; a third polymer layer; and a support polymer layer situated between the second layer and the third layer. Between the first layer and the second layer, a PV layer of the module is situated containing a cured composition made of poly(ethylene vinyl acetate) or silicone and photovoltaic cells situated therein, while the support layer comprises stiffening elements defining openings which extend in a direction perpendicular to the length of the first layer, and moreover, the support layer comprises a support first side adhering to the second layer and a support second side adhering to the third layer, whereas the support layer may comprise a stiffening core with structure of a honeycomb array, a triangular array, an R6 array, or a hexakis array. Openings in the honeycomb array may be empty of filled with a plastic foam.

The objective of the present invention is to develop a new compact design of a laminated thermally insulating photovoltaic module characterised with high rigidity, mechanical strength, and resistance to variable atmospheric conditions, including high resistance to moisture, with thickness of structure of its photovoltaic panel glass panes reduced to a minimum. A further objective of the invention is to develop such design of laminated thermally insulating photovoltaic module which will enable both construction of continuous external facade facings and integrating the module into laminated roof boards of building structures. The invention is defined in claim 1. The preferred embodiments are set out in the appended set of dependent claims.

The essential idea characterising the design of the laminated thermally insulating photovoltaic module according to the invention consists that its photovoltaic panel has a front glass pane and a back glass pane, both made of 0.5-1.8 mm thick chemically strengthened glass, which are laminated together with an array of photovoltaic cells by means of two sheets of encapsulation film, whereas the plate-shaped core of the module is made of springy thermally insulating foam characterised with high adhesion to surfaces of components joined permanently with said core, and the inner facing adjacent to the core is made preferably of 0.4-0.6-mm thick anodised aluminium sheet.

Both encapsulation films laminating the two glass panes together with the photovoltaic panel are favourably made of a ethylene-vinyl acetate copolymer or a vinyl polymer or a ionomer film.

The front copolymer encapsulation film used in the photovoltaic module has high solar radiation energy transmittance, while its back encapsulation film is a tinted film, and the plate core of the module is made preferably of polystyrene-polyurethane foam.

It is also favourable when the photovoltaic panel of the module has tinted back glass pane and transparent encapsulation film adhering thereto. Moreover, in the module according to the invention, its photovoltaic panel constitutes an array of monocrystalline photovoltaic cells or an array of polycrystalline photovoltaic cells, whereas the cells are manufactured with the use of the back-contact technology or MWT technology or DSSC technology or QDSC technology. The photovoltaic panel comprises also favourably perovskite photovoltaic cells.

Construction of the laminated thermally insulating photovoltaic module based on joining an outer facing with a photovoltaic panel comprising a photovoltaic cell or an array of photovoltaic cells disposed therein, with a metal inner facing of the panel joined rigidly and permanently with a core made of thermally insulating foam characterised with high adhesion to components joined with the core, especially polystyrene-polyurethane (PSUR) foam, secures proper conversion of energy carried by sunrays into electric power transmitted to appropriate transformation devices and distributed via the electric power grid infrastructure, ensuring at the same time high resistance of the module to variable atmospheric conditions, whereas composite material of the core ensures proper insulating properties, physicochemical stability, vapour-permeability, and easiness of installation work. Moreover, such composite structure of the photovoltaic module comprising chemically strengthened glass panes and aluminium inner (bottom) facing joined inseparably with each other by means of a foamed plastic characterised with high adhesion properties ensures proper rigidity and mechanical strength of the module, while using ultra-thin chemically strengthened glass panes enables minimising its thickness. Further, the possibility to integrate the photovoltaic module within multilayer insulating plate eliminates the need to construct additional structures necessary to install photovoltaic panels in photovoltaic systems, reducing thus the overall cost of construction work as installation of the panels integrated into the photovoltaic module according to the invention can be carried out in the course of providing walls of buildings with thermal insulation. Among merits of the photovoltaic module according to the invention one should mention also its aesthetic qualities consisting in the possibility to combine different types and colours of lamination films used to laminate the panel of the module. Moreover, the external electric connector assembly with its collectors, photovoltaic conductors, and electric junctions of the photovoltaic panel embedded in the foam core ensures reliable operation of the electric circuit providing electric power generated by photovoltaic cells as a result of interaction of sunlight from the photovoltaic panel of the module. Further, disposing a core made of springy thermally insulating foam of high adhesion between inner (bottom) sheet aluminium facing and the lower glass pane, side profiled edges of which being provided with profiled aluminium slat-shaped protective-assembly elements, enables integrating the photovoltaic module according to the invention with structure of a building wall. The thermally insulating foam applied between the above-mentioned components expands and tightly fills up any free space between them and after setting, it produces inseparable, rigid, and durable mechanical coupling between all components of the laminated thermally insulating photovoltaic module thanks to high adhesion between the foam and surfaces of the components which form thus a monolith with electric components carrying the generated electric current. Also the use of layers of an encapsulation film, preferably of ethylene-vinyl acetate copolymer, in the photovoltaic panel of the module ensures additionally both excellent electric insulation and protection against variable atmospheric conditions, whereas the bottom layer of the film protects this portion of the module against mechanical damage, weather conditions, chemicals, and UV radiation, and the use of chemically strengthened (by means of ion exchange method) glass panes with thickness from 0.5 mm to 1.8 mm minimises losses relating to light absorption and ensures high mechanical strength.

The subject of the invention is presented in its example embodiments explained in more details in connection with drawings, of which Fig. 1 is a perspective view of the first version of embodiment of the laminated thermally insulating photovoltaic module; Fig. 2 - a perspective view of the same module with its components disassembled; Fig. 3 - vertical cross-section of the same module along line A-A; Fig. 4 - vertical cross-section of the same module along line B-B; Fig. 5 - vertical cross-section of detail "C" of the same module; Fig. 6 -a perspective view of the second version of embodiment of the laminated thermally insulating photovoltaic module; Fig. 7 - a perspective view of the same second version of thermally insulating photovoltaic module with its components disassembled; Fig. 8 - vertical cross-section of the same second version of the photovoltaic module along line D-D; Fig. 9 - vertical cross-section of the same second version of the photovoltaic module along line E-E; and Fig. 10 - vertical cross-section of detail "F" of the same second version of the photovoltaic module.

### Example 1

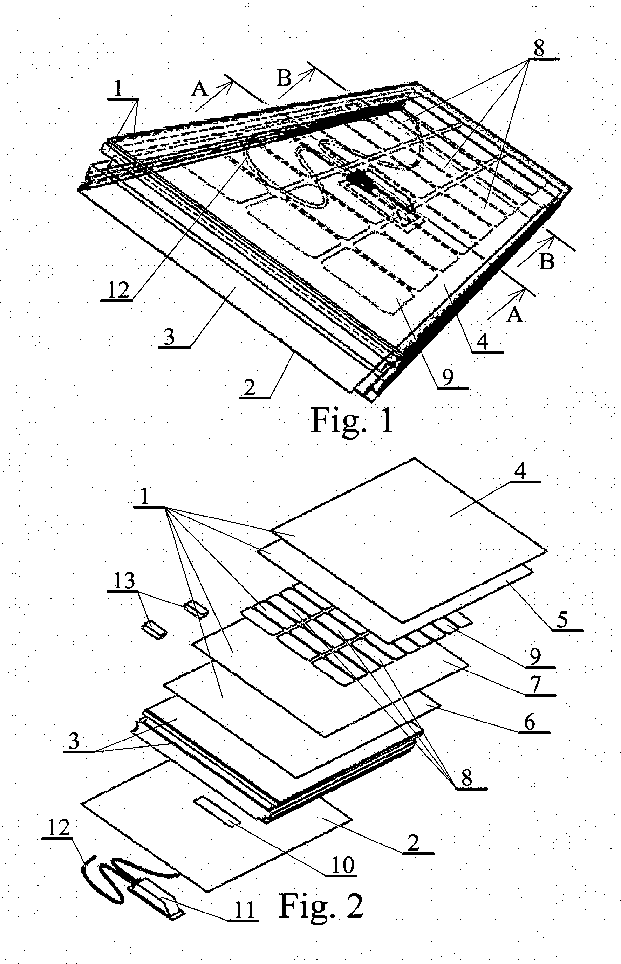

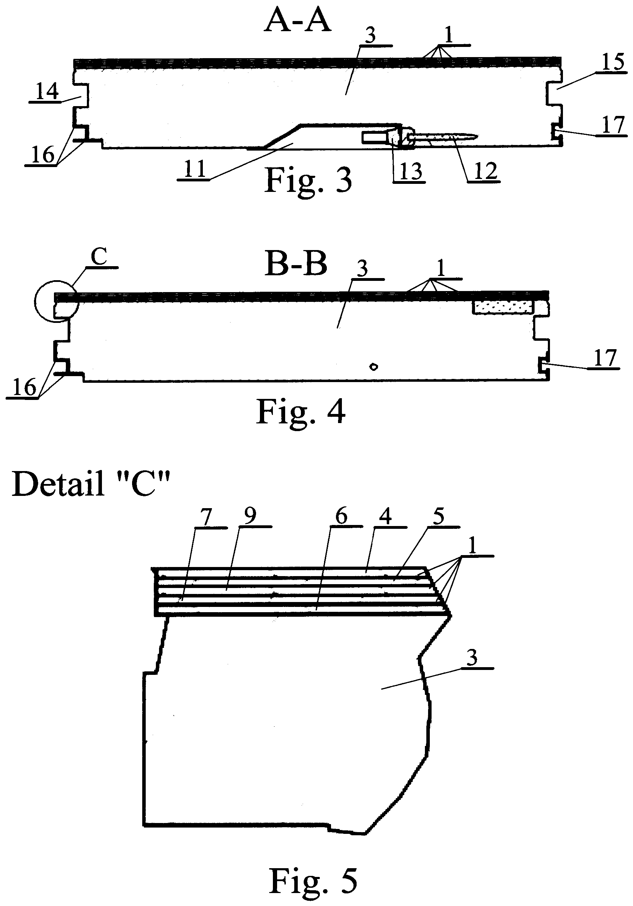

The laminated thermally insulating photovoltaic module according to the first version of its embodiment shown in Figs. 1-5 comprises a photovoltaic panel 1 functioning as an outer (front) facing and an inner (back) facing 2 with the plate-shaped thermally insulating core 3 disposed between the facings. Photovoltaic panel 1 of the module comprises a 0.85 mm thick front glass pane 4 chemically strengthened (by means of ion exchange method) with encapsulation film 5 adhering thereto and a chemically hardened back glass pane 6 of the same thickness with encapsulation film 7 also adhering thereto. Between the two films, an array 8 of monocrystalline photovoltaic cells 9 is disposed comprising thirty photovoltaic cells 9 arranged in three columns with ten cells per column connected to each other in series-parallel, so the array of cells together with ultra-thin glass panes 4 and 6 laminated together by means of these two films forms a single multilayer monolith of photovoltaic panel 1. Copolymer encapsulation film 5 made of ethylene-vinyl acetate (EVA) copolymer employed in the photovoltaic panel 1 has high solar radiation energy transmittance, whereas its back encapsulation film 7 also made of ethylene-vinyl acetate (EVA) copolymer is a tinted film with low transparence, and moreover, the panel is provided with a semiconductor protecting component (not shown in the figures), made in the form of diode operating as a by-pass.

Further, the inner or back facing 2 of photovoltaic panel 1 of the module is made of 0.4 mm thick anodised sheet aluminium and has an opening 10 extending all the way through, in which a housing with electric connector 11 is mounted with the use of silicone as well as photovoltaic conductors 12 connected with negative and positive pole of the array of photovoltaic cells 9, provided also with by-pass diodes (not shown in figures) protecting the panel against unfavourable impact of overshadowing. The back facing 2 is joined permanently with the back glass pane 6 of the panel by means of thermally insulating core 3 made of PSUR-type polystyrene-polyurethane foam characterised with high adhesion, inside which said photovoltaic conductors 12 are embedded together with housing of electric junction 11 and photovoltaic connector 13 of the photovoltaic panel 1. This springy foam playing the role of thermally insulating material fills up tightly the space between front facing 1 and back facing 2 of the laminated thermally insulating photovoltaic module. The two opposite longer side walls of the thermally insulating core are provided with slotted recesses 14 and 15 for sealant (not shown in the figures) and behind them, profiled recesses aluminium profiled slat-shaped assembling elements 16 and 17 are fixed which enable integration of the laminated photovoltaic module according to the invention with structure of a building wall.

### Example 2

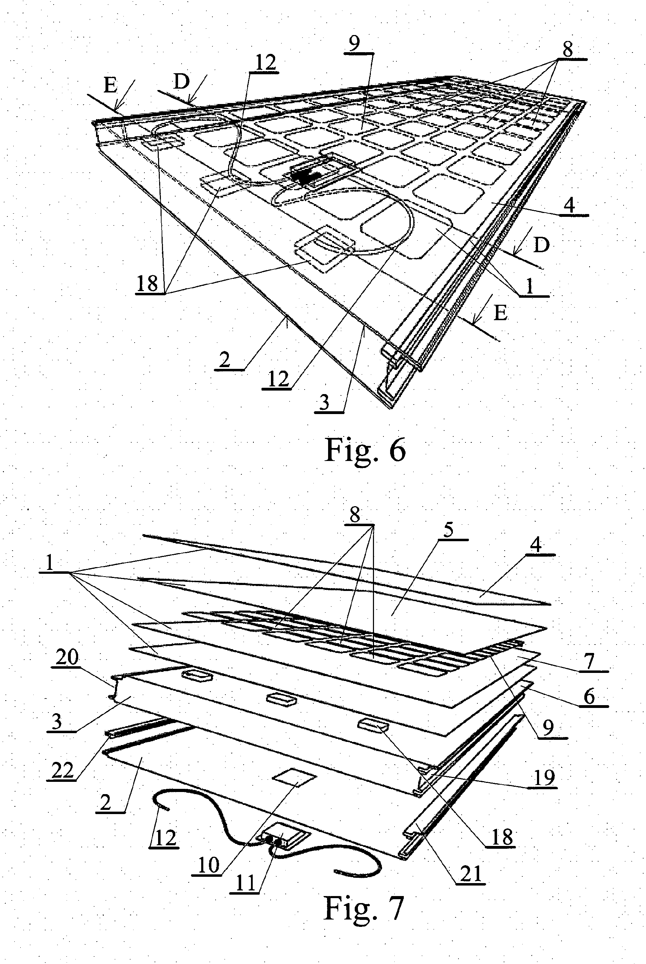

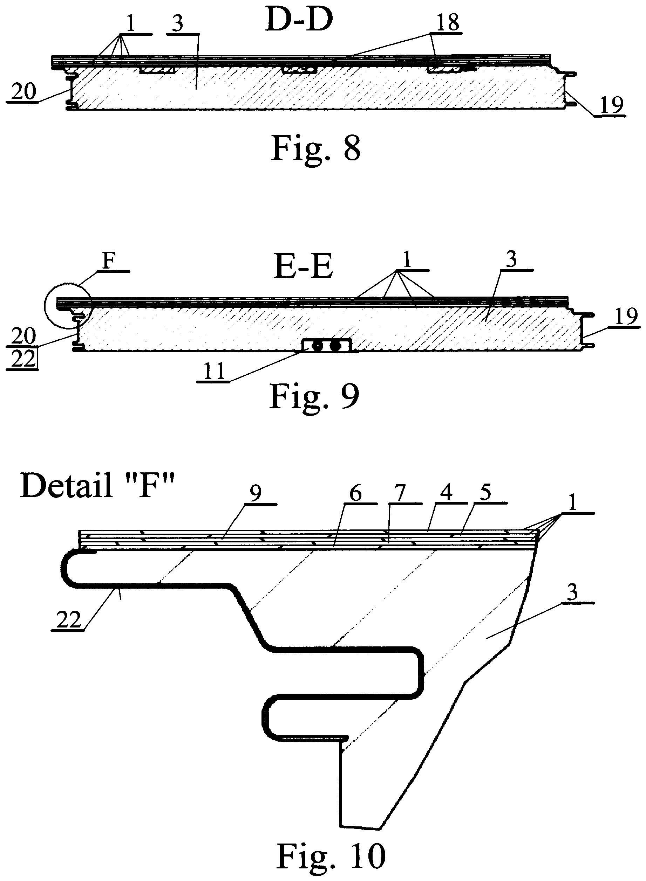

Laminated thermally insulating photovoltaic module according to the second version of its embodiment presented in Figs. 6-10 has a structure similar to this of the module described in the first example embodiment of the module, and the difference between the two photovoltaic modules consists in that:
- the array of photovoltaic cells 9 in the second version of embodiment of the module comprises sixty photovoltaic cells 9 manufactured with the use of the back-contact technology, and to protect its photovoltaic panel 1, three junction boxes 18 with semiconductor by-pass diodes (not shown in the figures) installed inside;
- both longer walls of thermally insulating core 3 of the module together with its 0.6 mm thick back aluminium facing 2 are provided with profiled recesses 19 and 20, with a 0.6 mm thick profiled aluminium slat 21 fixed in recess 19 and a slat-shaped profiled sheath 22 fixed in recess 20, said sheath playing the role of a cover protecting back portion of the module, whereas the profiled slat 21 enables joining the photovoltaic panel according to the invention by means of self-drilling screws or assembly bolts to load-bearing structure of a building;
- thermally insulating core in this version of the module was made of polyurethane foam of PUR type, ensuring also durable and rigid integration of all module components;
- glass panes 4 and 6 were made of 0.5-mm thick chemically hardened glass, whereas to laminate them together, encapsulation film 5 and 7 was used made of polyvinyl butyral (PVB).

### Example 3

Laminated thermally insulating photovoltaic module according to the third version of its embodiment (not shown in the figures) has structure identical to this of the module described in the first of its example embodiments, and the difference between the two photovoltaic modules consists only in that:
in the array 8 of photovoltaic cells, polycrystalline photovoltaic cells 9 were used;
- the front glass pane 4 and the back pane 6 of the photovoltaic panel 1 of the module were made of 1.8-mm thick chemically strengthened glass, whereas in this version, tinted back glass pane 6 and transparent encapsulation film 7 adjacent thereto were used; and
- the thermally insulating core was made of thermally insulating foam of PIR type, and further, ionomer encapsulation films 5 and 7 were used to laminate glass panes 4 and 6 together.

### Example 4

The laminated thermally insulating photovoltaic module according a fourth version of its embodiment has also a structure similar to this of the module described in the first example of its embodiment, and the difference between them consists only in that:
its thermally insulating core was made of thermally insulating foam of PIR type, and
photovoltaic cells 9 of photovoltaic panel 1 of the module were manufactured with the use of metal wrap-through (MWT) technology.

In further example embodiments of the photovoltaic module described in Examples 1 and 2 and presented in Figs. 1-10, the used photovoltaic cells 9 included those made with the use of Dye-sensitised Solar Cell (DSSC) technology, or made with the use of Quantum Dots Solar Cell (QDSC) technology, or perovskite cells, whereas the aluminium back facing of the module was made of sheet aluminium with a protective coating or of a plastic resistant to variable atmospheric conditions.

As a result of a series of tests it has been found that photovoltaic conductors 12 and by-pass diodes disposed inside the photovoltaic panel 1 of the module ensure proper safety of its operation, provide protection against electric overload, and counteract burning holes in the back encapsulation film caused by the so-called "hot spot effect". Further, it was found that equipping the panel in connectors, especially of MC4 type, facilitates connection operations and protects its electric components against coming into contact with the environment.

## Claims

1. A laminated thermally insulating photovoltaic module comprising an outer facing (2) constituting a photovoltaic panel (1) formed by two glass panes (4, 6), a front glass pane (4) and back glass pane (6), with electrically insulating encapsulation films (5, 7) adhering to the two glass panes (4, 6) and with an array (8) of photovoltaic cells (9) connected electrically to each other and disposed between the encapsulation films (5, 7), equipped with a junction box (18) and photovoltaic conductors (12), wherein the components are laminated together by means of these electrically insulating encapsulation films forming a single monolith of the panel, **characterised in that** to the back glass pane (6) of the single monolith of the panel adheres a plate core (3) made of insulating foam and covered with an inner facing (2), wherein the front and back glass panes (4, 6) are made of 0.5-1.8-mm thick chemically strengthened glass, wherein the plate core (3) of the module is made of springy thermally insulating foam characterised with high adhesion to permanently join the core (3) with the back glass pane (6) and the inner facing (2), and the inner facing (2) is made preferably of 0.4-0.6 mm thick anodised sheet aluminium.

2. The laminated thermally insulating module according to claim 1 **characterised in that** the encapsulation films (5, 7) are made of ethylene-vinyl acetate copolymer.

3. The laminated thermally insulating module according to claim 1 **characterised in that** the encapsulation films (5, 7) are made of a vinyl polymer.

4. The laminated thermally insulating module according to claim 1 **characterised in that** the encapsulation films (5, 7) are ionomer films.

5. The laminated thermally insulating module according to claim 1 **characterised in that** the encapsulation film (5), which is in front of photovoltaic panel (1) has high solar radiation energy transmittance, whereas the encapsulation film (7), which is in back of photovoltaic panel (1) is a tinted film.

6. The laminated thermally insulating module according to claim 1 **characterised in that** the plate core (3) is made preferably of polystyrene-polyurethane foam.

7. The laminated thermally insulating module according to claim 1 **characterised in that** the back glass pane (6) is tinted and the encapsulation film (7) adhered to the back glass pane (6) is transparent.

8. The laminated thermally insulating module according to claim 1 **characterised in that** the photovoltaic panel (1) is the array (8) of the photovoltaic cells (9), which are monocrystalline.

9. The laminated thermally insulating module according to claim 1 **characterised in that** the photovoltaic panel (1) is the array (8) of the photovoltaic cells (9), which are polycrystalline.

10. The laminated thermally insulating module according to claim 1 **characterised in that** the photovoltaic panel (1) comprises photovoltaic cells (9) manufactured with the use of back-contact technology.

11. The laminated thermally insulating module according to claim 1 **characterised in that** the photovoltaic panel (1) comprises the photovoltaic cells (9) manufactured with the use of MWT technology.

12. The laminated thermally insulating module according to claim 1 **characterised in that** the photovoltaic panel (1) comprises the photovoltaic cells (9) manufactured with the use of DSSC technology.

13. The laminated thermally insulating module according to claim 1 **characterised in that** the photovoltaic panel (1) comprises the photovoltaic cells (9) manufactured with the use of QDSC.

14. The laminated thermally insulating module according to claim 1 **characterised in that** the photovoltaic panel (1) comprises the photovoltaic cells (9) which are perovskite.

## Patentansprüche

1. Ein laminiertes wärmedämmendes Photovoltaikmodul, das eine äußere Verkleidung (2) umfasst, die ein Photovoltaikpaneel (1) darstellt, das aus zwei Glasscheiben (4, 6) gebildet wird, einer vorderen Glasscheibe (4) und einer hinteren Glasscheibe (6), mit elektrisch isolierenden Verkapselungsfolien (5, 7), die an den zwei Glasscheiben (4, 6) kleben, und mit einem Generator (8) aus Photovoltaikzellen (9), die elektrisch aneinander angeschlossen sind und zwischen den Verkapselungsfolien (5, 7) eingereiht sind, ausgestattet mit einem Anschlusskasten (18) und Photovoltaikleitern (12), wobei die Komponenten miteinander laminiert sind, mithilfe dieser elektrisch isolierten Verkapselungsfolien, und so einen einzelnen Monolith des Paneels bilden, **gekennzeichnet dadurch, dass** an der Rückseite der Glasscheibe (6) des einzelnen Monoliths des Paneels ein Plattenkern (3) klebt, der aus Dämmschaum besteht und mit einer inneren Verkleidung (2) abgedeckt ist, wobei die vordere und hintere Glasscheibe (4, 6) aus 0,5-1,8 mm dickem, chemisch verstärktem Glas besteht, wobei der Plattenkern (3) des Moduls aus federndem Wärmedämmschaum besteht, der sich durch eine hohe Haftung auszeichnet, um sich permanent dem Kern (3) mit der hinteren Glasscheibe (6) und der inneren Verkleidung (2) anzuschließen, und die innere Verkleidung (2) besteht vorzugsweise aus 0,4-0,6 mm dickem anodisierten Aluminiumblech.

2. Das laminierte wärmedämmende Modul gemäß Anspruch 1, **gekennzeichnet dadurch, dass** die Verkapselungsfolien (5, 7) aus EthylenVinylacetat-Copolymer gefertigt sind.

3. Das laminierte wärmedämmende Modul gemäß Anspruch 1, **gekennzeichnet dadurch, dass** die Verkapselungsfolien (5, 7) aus VinylPolymer gefertigt sind.

4. Das laminierte wärmedämmende Modul gemäß Anspruch 1, **gekennzeichnet dadurch, dass** die Verkapselungsfolien (5, 7) Ionomer-Folien sind.

5. Das laminierte wärmedämmende Modul gemäß Anspruch 1, **gekennzeichnet dadurch, dass** die Verkapselungsfolie (5), die sich vor dem Photovoltaikpaneel (1) befindet, einen hohen Durchlassgrad für die Strahlungsenergie der Sonne hat, während die Verkapselungsfolie (7), die sich auf der Rückseite des Photovoltaikpaneels (1) befindet, eine getönte Folie ist.

6. Das laminierte wärmedämmende Modul gemäß Anspruch 1, **gekennzeichnet dadurch, dass** der Plattenkern (3) vorzugsweise aus Polystyrol-Polyurethan-Schaum gefertigt ist.

7. Das laminierte wärmedämmende Modul gemäß Anspruch 1, **gekennzeichnet dadurch, dass** die hintere Glasscheibe (6) getönt ist, und die an die hintere Glasscheibe (6) geklebte Verkapselungsfolie (7) transparent ist.

8. Das laminierte wärmedämmende Modul gemäß Anspruch 1, **gekennzeichnet dadurch, dass** das Photovoltaikpaneel (1) der Generator (8) der Photovoltaikzellen (9) ist, die monokristallin sind.

9. Das laminierte wärmedämmende Modul gemäß Anspruch 1, **gekennzeichnet dadurch, dass** das Photovoltaikpaneel (1) der Generator (8) der Photovoltaikzellen (9) ist, die polykristallin sind.

10. Das laminierte wärmedämmende Modul gemäß Anspruch 1, **gekennzeichnet dadurch, dass** das Photovoltaikmodul (1) Photovoltaikzellen (9) umfasst, die mit der Rückkontakt-Technologie hergestellt wurden.

11. Das laminierte wärmedämmende Modul gemäß Anspruch 1, **gekennzeichnet dadurch, dass** das Photovoltaikmodul (1) Photovoltaikzellen (9) umfasst, die mit der MWT-Technologie hergestellt wurden.

12. Das laminierte wärmedämmende Modul gemäß Anspruch 1, **gekennzeichnet dadurch, dass** das Photovoltaikmodul (1) Photovoltaikzellen (9) umfasst, die mit der ofDSSC-Technologie hergestellt wurden.

13. Das laminierte wärmedämmende Modul gemäß Anspruch 1, **gekennzeichnet dadurch, dass** das Photovoltaikmodul (1) Photovoltaikzellen (9) umfasst, die mit QDSC hergestellt wurden.

14. Das laminierte wärmedämmende Modul gemäß Anspruch 1, **gekennzeichnet dadurch, dass** das Photovoltaikpaneel (1) die Photovoltaikzellen (9) umfasst, die aus Perowskit sind.

## Revendications

1. Module photovoltaïque feuilleté à isolation thermique comprenant une face (2) extérieure constituant un panneau (1) photovoltaïque formé par deux vitres (4, 6), une vitre (4) avant et une vitre (6) arrière, comportant des feuilles (5, 7) encapsulantes électriquement isolantes adhérant aux deux vitres (4, 6) et comportant une matrice (8) de cellules (9) photovoltaïques connectées électriquement les unes entre les autres et disposées entre les feuilles (5, 7) encapsulantes, équipée d'une boîte de jonction (18) et des conducteurs (12) photovoltaïques, dans lequel les composants sont conjointement stratifiés au moyen desdites feuilles encapsulantes électriquement isolantes formant un monobloc du panneau, **caractérisé en ce que** à la vitre (6) arrière du monobloc du panneau adhère un noyau (3) plat en mousse isolante et recouvert d'un face (2) intérieure, dans lequel les vitres (4, 6) avant et arrière sont constituées de verre renforcé chimiquement de 0,5 à 1,8 mm d'épaisseur, dans lequel le noyau (3) plat du module est constitué d'une mousse à isolation thermique élastique **caractérisée par** une adhérence élevée permettant de joindre de manière permanente le noyau (3) à la vitre (6) arrière et à la face (2) intérieure, et la face (2) intérieur est, de préférence en tôle d'aluminium anodisé de 0,4 à 0,6 mm d'épaisseur.

2. Module stratifié à isolation thermique selon la revendication 1, **caractérisé en ce que** les feuilles (5, 7) encapsulantes sont en copolymère éthylène-acétate de vinyle.

3. Module stratifié à isolation thermique selon la revendication 1, **caractérisé en ce que** les feuilles (5, 7) encapsulantes sont en polymère vinylique.

4. Module stratifié à isolation thermique selon la revendication 1, **caractérisé en ce que** les feuilles (5, 7) encapsulantes sont des feuilles ionomères.

5. Module stratifié à à isolation thermique selon la revendication 1, **caractérisé en ce que** la feuille (5) encapsulante, laquelle se trouve devant le panneau (1) photovoltaïque présente un facteur élevé de transmission d'énergie de rayonnement solaire, la feuille (7) encapsulante, laquelle se trouve à l'arrière du panneau (1) photovoltaïque est une feuille teintée.

6. Module stratifié à isolation thermique selon la revendication 1, **caractérisé en ce que** le noyau (3) plat est, de préférence en mousse polystyrène polyuréthane.

7. Module stratifié à isolation thermique selon la revendication 1, **caractérisé en ce que** la vitre (6) arrière est teintée et la feuille (7) encapsulante collée à la vitre (6) arrière est transparente.

8. Module stratifié à isolation thermique selon la revendication 1, **caractérisé en ce que** le panneau (1) photovoltaïque est la matrice (8) de cellules (9) photovoltaïques, lesquelles sont monocristallines.

9. Module stratifié à isolation thermique selon la revendication 1, **caractérisé en ce que** le panneau (1) photovoltaïque est la matrice (8) de cellules (9) photovoltaïques, lesquelles sont polycristallines.

10. Module stratifié à isolation thermique selon la revendication 1, **caractérisé en ce que** le panneau (1) photovoltaïque comprend des cellules (9) photovoltaïques fabriquées à l'aide de la technologie de contact arrière.

11. Module stratifié à isolation thermique selon la revendication 1, **caractérisé en ce que** le panneau (1) photovoltaïque comprend des cellules (9) photovoltaïques fabriquées à l'aide de la technologie MWT.

12. Module stratifié à isolation thermique selon la revendication 1, **caractérisé en ce que** le panneau (1) photovoltaïque comprend les cellules (9) photovoltaïques fabriquées à l'aide de la technologie DSSC.

13. Module stratifié à isolation thermique selon la revendication 1, **caractérisé en ce que** le panneau (1) photovoltaïque comprend les cellules (9) photovoltaïques fabriquées à l'aide de QDSC.

14. Module stratifié à isolation thermique selon la revendication 1, **caractérisé en ce que** le panneau (1) photovoltaïque comprend les cellules (9) photovoltaïques, lesquelles sont en pérovskite.
